# EUROPEAN PATENT SPECIFICATION

(11) **EP 3 553 203 B1**
(45) Date of publication and mention of the grant of the patent: **30.11.2022**
(21) Application number: 19733387.5
(22) Date of filing: 01.02.2019
(51) Int. Cl.: C23C 14/58, C23C 14/16, C23C 14/20, C23C 14/24, H01M 4/134, H01M 4/1395, H01M 4/38, H01M 4/62, H01M 4/04, C23C 14/56, H01M 4/02, H01M 10/052

(54) **THIN FILM FORMATION METHOD AND THIN FILM FORMATION DEVICE**
DÜNNSCHICHTFORMUNGSVERFAHREN UND DÜNNSCHICHTFORMUNGSVORRICHTUNG
PROCÉDÉ DE FORMATION DE FILM MINCE ET DISPOSITIF DE FORMATION DE FILM MINCE

(30) Priority: 07.02.2018 JP 2018019784
(43) Date of publication of application: 16.10.2019
(73) Proprietor: ULVAC, Inc., Chigasaki-shi, Kanagawa 253-8543 (JP)
(72) Inventor: GIBO, Manabu, Chigasaki-shi, Kanagawa 2538543 (JP); SASAKI, Shunsuke, Chigasaki-shi, Kanagawa 2538543 (JP); KIMOTO, Takahito, Chigasaki-shi, Kanagawa 2538543 (JP)
(74) Representative: Michalski Hüttermann & Partner Patentanwälte mbB
(86) International application number: PCT/JP2019/003723
(87) International publication number: WO 2019/156005

(56) References cited:
- EP-A1- 2 475 042
- EP-A1- 3 547 411
- WO-A1-2011/018980
- WO-A1-2012/005126
- JP-A- H01 211 856
- JP-A- H06 124 700
- JP-A- 2012 017 478
- US-B2- 6 780 542
- Nor Fatin Khairah Bahanurddin: "EFFECT OF DIFFERENT COMPACTION PRESSURE AND DIFFERENT SINTERING ROUTE ON K0.5NA0.5NBO3 PHYSICAL AND DIELECTRIC PROPERTIES", CERAMICS-SILIKATY, 30 August 2016 (2016-08-30), pages 220-225, XP055738092, CZ ISSN: 0862-5468, DOI: 10.13168/cs.2016.0033

## Description

### Technical Field

The present invention relates to a thin film formation method and a thin film formation apparatus, in which a lithium metal film is formed on a base material by evaporating lithium metal.

### Background Art

In recent years, along with development of mobile devices such as a mobile phone and a smartphone, lithium batteries which are installed in those devices are attracting attention. For the lithium batteries, a step of forming lithium metal on a base material is especially important in the manufacturing process, and various technologies have been proposed.

For example, Patent Literature 1 describes a technology of forming lithium metal on a base material by evaporating lithium metal in a chamber and depositing scattered particles on the base material. Here, Patent Literature 1 describes a technology of suppressing degradation of a lithium metal film by forming a protection film made of lithium carbonate on a surface of the lithium metal film.

Patent Literature 1: Japanese Patent Application Laid-open No. 2012-017478

WO 2012/005126 A1 describes a lithium laminated member which is capable of improving the performance of a lithium film; and a method for producing the lithium laminated member.

EP 2 475 042 A1 describes a technique for producing a thin film lithium secondary battery is provided, which does not change the properties of a metallic lithium film as a negative electrode.

US 6780542 B2 is directed to providing a lithium carbonate passivation layer on lithium through exposure of the active material to gaseous carbon dioxide prior to cell assembly.

### Disclosure of Invention

### Technical Problem

In Patent Literature 1, the protection film made of lithium carbonate is formed on the surface of the lithium metal film by moving a lithium laminated member in which the lithium metal film is formed on the base material into a treatment chamber from which moisture has been removed and introducing inert gas including carbon dioxide gas into this treatment chamber.

However, in the method above, it is sometimes impossible to stably form the protection film made of lithium carbonate in the entire region of the surface of the lithium metal film. Therefore, there is a problem that a lithium hydroxide film is grown in a region in which the protection film is insufficiently formed when it is exposed to the atmosphere, and desired electrical characteristics cannot be secured.

In view of the above-mentioned circumstances, it is an object of the present invention to provide a thin film formation method, a thin film formation apparatus, and a lithium battery by which a protection film made of lithium carbonate can be stably formed in an entire region of a surface of a lithium metal film.

### Solution to Problem

The invention is defined by the features of the independent claim.

In order to accomplish the above-mentioned object, a thin film formation method according to an embodiment of the present invention includes depositing a lithium metal film on a base material in a vacuum chamber.

A surface of the lithium metal film is oxidized in the vacuum chamber.

The oxidized surface of the lithium metal film is carbonized in the vacuum chamber.

In the thin film formation method, the protection film made of lithium carbonate is formed in the entire region of the surface of the lithium metal film by oxidizing the surface of the lithium metal film and carbonizing the oxidized surface of the lithium metal film. The lithium oxidation reaction has a higher efficiency than the carbonization reaction. Therefore, the entire region of the surface of the lithium metal film can be stably oxidized. In addition, the protection film made of lithium carbonate can be stably formed in the entire region of the surface of the lithium metal film by carbonization treatment thereafter.

The step of oxidizing the surface of the lithium metal film may include forming a lithium oxide film having a first thickness on the surface, and the step of carbonizing the surface of the lithium metal film may include forming a lithium carbonate film having a second thickness on the surface, the second thickness being equal to or smaller than the first thickness.

That is, the entire lithium oxide of the lithium metal film surface may be converted into the lithium carbonate by carbonization treatment or a predetermined thickness range of a surface layer of the lithium oxide may be converted into the lithium carbonate.

A thin film formation apparatus according to an embodiment of the present invention includes a deposition section, a first treatment section, and a second treatment section.

The deposition section includes an evaporation source of lithium metal and forms a lithium metal film on a base material.

The first treatment section includes a first treatment chamber for oxidizing a surface of the lithium metal film.

The second treatment section includes a second treatment chamber for carbonizing the oxidized surface of the lithium metal film.

### Advantageous Effects of Invention

As described above, in accordance with the present invention, a protection film made of lithium carbonate can be stably formed in an entire region of a surface of a lithium metal film.

### Brief Description of Drawings

[Fig. 1] A process diagram showing a thin film formation method according to an embodiment of the present invention.
[Fig. 2] A flowchart showing a treatment procedure of the thin film formation method.
[Fig. 3] A schematic configuration diagram of a thin film formation apparatus according to an embodiment of the present invention.
[Fig. 4] A schematic cross-sectional view of a thin film formation apparatus according to another embodiment of the present invention.

### Mode(s) for Carrying Out the Invention

Hereinafter, an embodiment of the present invention will be described with reference to the drawings.

### [Thin Film Formation Method]

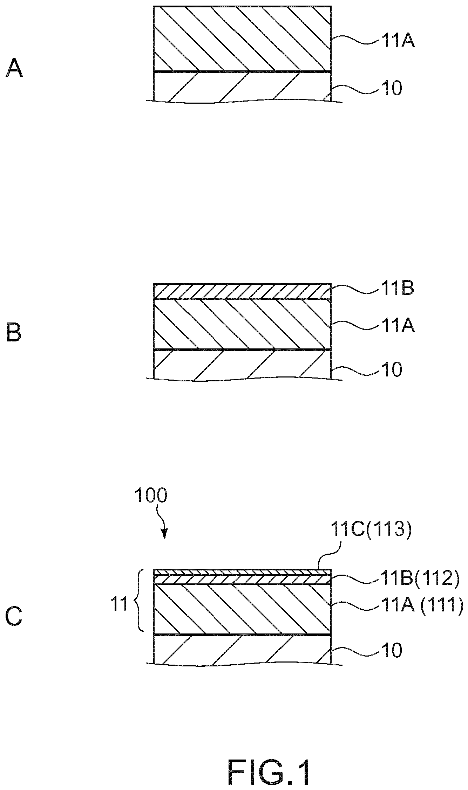

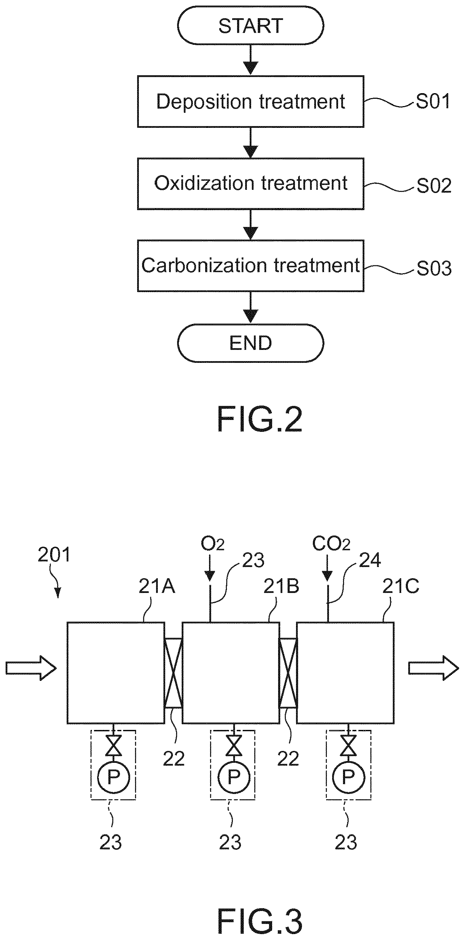

Fig. 1 is a process diagram showing a thin film formation method according to an embodiment of the present invention and Fig. 2 is a flowchart showing a treatment procedure of the thin film formation method.

In this embodiment, a formation method for a lithium electrode 11 (see C of Fig. 1) that constitutes a negative electrode of the lithium battery will be described.

The thin film formation method of this embodiment includes a deposition treatment (Step 01), an oxidization treatment (Step 02), and a carbonization treatment (Step 03).

### (Deposition Treatment)

As shown in A of Fig. 1, a lithium metal film 11A is formed on a surface of a base material 10 in the deposition treatment.

The deposition method is not particularly limited and vacuum deposition is typically employed. The base material 10 is typically constituted by a plate material of a metal material such as copper and stainless steel. The base material 10 may have flexibility and may have rigidity. The deposition type is also not particularly limited and may be a batch type or may be a roll-to-roll type. The thickness of the lithium metal film 11A is also not particularly limited and is several µm to several tens of µm for example.

### (Oxidization Treatment)

In the oxidization treatment, as shown in B of Fig. 1, a lithium oxide film 11B having a predetermined thickness is formed by oxidizing the surface of the lithium metal film 11A.

The oxidization treatment is typically performed in a treatment chamber different from a deposition chamber for the lithium metal film 11A. Oxidizing gas is oxygen or a mixture gas of oxygen and argon and the like is typically used.

Not limited thereto, the oxidization treatment can also be conducted in a deposition chamber of the lithium metal film 11A. In this case, the lithium oxide film 11B can be formed on the surface of the lithium metal film 11A by introducing oxygen or mixture gas of oxygen and argon and the like into the deposition chamber after formation of the lithium metal film 11A and keeping it for a predetermined time (e.g., 1 minute).

The thickness (first thickness) of the lithium oxide film 11B is not particularly limited and 10 nm or more and 150 nm or less for example. With this configuration, it is possible to stably ensure predetermined electrical characteristics required as a negative-electrode material while stably forming a lithium carbonate film 11C (C of Fig. 1) to be described later.

That is, if the thickness of the lithium oxide film 11B is less than 10 nm, it is difficult to uniformly form the lithium oxide film 11B on the surface of the lithium metal film 11A and form the lithium carbonate film 11C with a predetermined thickness or more. On the other hand, if the thickness of the lithium oxide film 11B is larger than 150 nm, the lithium carbonate film 11C can be formed with a sufficient thickness but the lithium ion conductivity may be lowered.

### (Carbonization Treatment)

In the carbonization treatment, as shown in C of Fig. 1, the lithium carbonate film 11C having the predetermined thickness is formed by carbonizing the surface of the lithium metal film 11A. Carbonizing gas is carbon monoxide, carbon dioxide, or mixture gas of them and argon and the like is typically used.

The carbonization treatment is typically performed in the deposition chamber of the lithium metal film 11A and a treatment chamber different from the treatment chamber for oxidizing the surface of the lithium metal film 11A. Not limited thereto, the carbonization treatment may be configured by the treatment chamber identical to the treatment chamber for oxidizing the surface of the lithium metal film 11A. In this case, the types of gas to be introduced into the treatment chamber are configured to be switchable.

The lithium carbonate film 11C is formed by subjecting the lithium oxide film 11B to carbonization. Therefore, the thickness (second thickness) of the lithium carbonate film 11C is formed with a thickness equal to or smaller than the thickness of the lithium oxide film 11B. In this embodiment, the lithium carbonate film 11C is formed with a thickness of 10 nm or more and 50 nm or less for example. With this configuration, the surface of the lithium metal film 11A can be effectively protected from hydroxylation and nitridization.

The lithium carbonate film 11C is formed by subjecting the lithium oxide film 11B to carbonization. Therefore, it is most favorable that the entire lithium oxide film 11B is replaced by the lithium carbonate film 11C.

A negative electrode 100 for a lithium metal battery of this embodiment which is formed in the above-mentioned manner includes the metal base material 10 and the lithium electrode 11 as shown in C of Fig. 1.

The lithium electrode 11 is constituted by a laminated film including a lithium metal layer 111 (11A) disposed on the base material 10, a lithium carbonate layer 113 (11C), and a lithium oxide layer 112 (11B) positioned between the lithium metal layer 111 and the lithium carbonate layer 113.

Although not shown in the figure, the lithium metal battery (not according to the claims) is configured in such a manner that the lithium carbonate layer 113 of the lithium electrode 11 is disposed facing the positive electrode with electrolyte solution provided therebetween. The lithium metal battery may be a primary battery or may be a secondary battery. The positive electrode is constituted by a manganese oxide-based material such as manganese dioxide for example, though not limited thereto as a matter of course.

The lithium electrode 11 of this embodiment has the lithium carbonate layer 113 made of the protection film (the lithium carbonate film 11C) on the surface. Therefore, formation of hydroxide or nitride on the surface due to exposure to the atmosphere can be suppressed.

As described above, in this embodiment, the protection film made of lithium carbonate (11C) is formed in the entire region of the surface of the lithium metal film 11A by oxidizing the surface of the lithium metal film 11A and carbonizing the oxidized surface of the lithium metal film. The lithium oxidation reaction has a higher efficiency than the carbonization reaction. Therefore, the entire region of the surface of the lithium metal film can be stably oxidized. In addition, the protection film made of lithium carbonate can be stably formed in the entire region of the surface of the lithium metal film by carbonization treatment thereafter.

In addition, in the step of oxidizing the surface of the lithium metal film 11A, the lithium oxide film 11B having the first thickness is formed on the surface of the lithium metal film 11A. In the step of carbonizing the surface of the lithium metal film 11A, the lithium carbonate film having the second thickness equal to or smaller than the first thickness is formed on the surface of the lithium metal film 11A. That is, at least part of lithium oxide of the lithium metal film surface is converted into lithium carbonate by the above-mentioned carbonization treatment. Therefore, the total thickness of the lithium oxide film 11B and the lithium carbonate film 11C can be minimized. With this configuration, it is possible to improve the battery characteristics while suppressing lowering of the lithium ion conductivity.

### [Thin Film Formation Apparatus]

Next, a formation apparatus for the lithium electrode 11 will be described.

Fig. 3 is a schematic configuration diagram of a thin film formation apparatus 201 according to an embodiment of the present invention. The thin film formation apparatus 201 shown in the figure is configured as a batch-type thin film formation apparatus.

The thin film formation apparatus 201 includes a deposition section 21A, a first treatment section 21B, and a second treatment section 21C. The deposition section 21A and the first and second treatment sections 21B and 21C are constituted by a plurality of treatment chambers connected via the gate valves 22 in order and are each configured to be capable of depressurizing the inside to a predetermined pressure via a vacuum evacuation apparatus 23.

The vacuum evacuation apparatus 23 is not limited to the case where it is individually connected to each chamber as shown in the figure. The vacuum evacuation apparatus 23 may be commonly connected to the respective chambers. Further, although not shown in the figure, load lock chambers for loading and unloading may be respectively provided on a base material carrying-in side of the deposition section 21A and on a base material carrying-out side of the second treatment section 21C.

The deposition section 21A includes a lithium metal evaporation source and is configured to be capable of forming the lithium metal film 11A on the carried-in base material 10.

The first treatment section 21B includes an oxygen supply line 23 capable of introducing oxygen and is configured to be capable of forming the lithium oxide film 11B by oxidizing the surface of the lithium metal film 11A.

The second treatment section 21C includes a carbon dioxide gas supply line 24 capable of introducing carbon dioxide (or carbon monoxide) and is configured to be capable of forming the lithium carbonate film 11C by carbonizing the oxidized surface of the lithium metal film.

The thin film formation apparatus 201 includes a conveying mechanism that sequentially conveys the base material 10 to the deposition section 21A, the first treatment section 21B, and the second treatment section 21C via the gate valves 22. With this configuration, it is possible to sequentially perform deposition of the lithium metal film 11A, formation of the lithium oxide film 11B, and formation of the lithium carbonate film 11C.

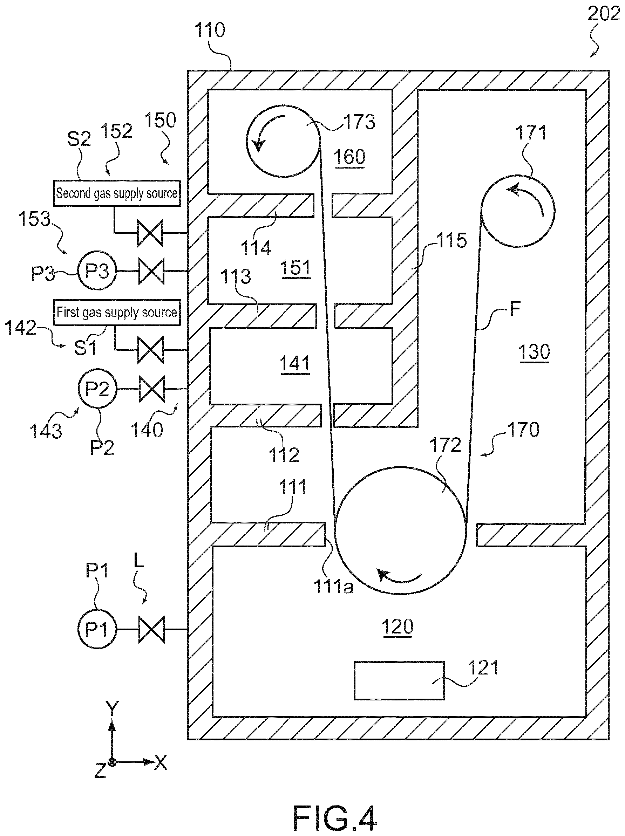

Fig. 4 is a schematic configuration diagram of a thin film formation apparatus 202 according to another embodiment of the present invention. The thin film formation apparatus 201 shown in the figure is configured as a roll-to-roll-type thin film formation apparatus.

As shown in Fig. 4, the thin film formation apparatus 202 includes a vacuum chamber 110, a deposition section 120, a conveying section 130, a first treatment section 140, a second treatment section 150, a recovering section 160, and a conveying mechanism 170.

The vacuum chamber 110 has a hermetically sealed structure and is connected to an evacuation line L of a vacuum pump P1. With this configuration, the vacuum chamber 110 is configured such that the inside can be evacuated or maintained at a predetermined pressure-reduced atmosphere. Further, as shown in Fig. 4, the vacuum chamber 110 includes a plurality of partition plates 111, 112, 113, 114, and 115 that respectively partition the deposition section 120, the conveying section 130, the treatment chamber 141, the treatment chamber 151, and the recovering section 160.

The deposition section 120 is a deposition chamber partitioned by the partition plate 111 and an outer wall of the vacuum chamber 110 and includes an evaporation source 121 therein. The evaporation source 121 is a lithium evaporation source that evaporates lithium metal and is constituted by a resistance heating type evaporation source, an induction heating type evaporation source, an electronic beam heating type evaporation source, and the like for example.

The deposition section 120 is connected to the evacuation line L. With this configuration, when the vacuum chamber 110 is evacuated, the deposition section 120 is first evacuated. On the other hand, the deposition section 120 is in communication with the conveying section 130, and thus when the deposition section 120 is evacuated, the conveying section 130 is also evacuated. With this configuration, a pressure difference between the deposition section 120 and the conveying section 130 is caused. This pressure difference makes it difficult for a steam stream of a lithium raw material to enter the conveying section 130.

The conveying section 130 is a conveying chamber partitioned by the partition plates 111, 112, and 115 and the outer wall of the vacuum chamber 110 and is disposed in an inner upper area of the vacuum chamber 110 in the Y-axis direction. In this embodiment, the first evacuation line L is connected only to the deposition section 120. However, the conveying section 130 and the deposition section 120 may be independently evacuated by connecting another evacuation line also to the conveying section 130.

The first treatment section 140 includes a treatment chamber 141, a gas supply line 142, and a pressure adjustment mechanism 143.

The treatment chamber 141 is connected to the gas supply line 142 including a gas supply source S1. With this configuration, the treatment chamber 141 is configured such that the first gas can be introduced into the treatment chamber 141. The first gas is not particularly limited as long as it is gas including oxygen. The first gas is oxygen or mixture gas of it and argon.

The treatment chamber 141 is connected to the pressure adjustment mechanism 143 including a pump P2. With this configuration, the treatment chamber 141 is maintained at a predetermined pressure-reduced atmosphere and the gas pressure of the first gas in the treatment chamber 141 is adjusted at a predetermined pressure.

In this embodiment, when the first gas introduced in the treatment chamber 141 is discharged, the treatment chamber 141 is first evacuated. On the other hand, the treatment chamber 141 is in communication with the conveying section 130, and thus the conveying section 130 is also evacuated when the treatment chamber 141 is evacuated. With this configuration, a pressure difference is caused between the treatment chamber 141 and the conveying section 130. This pressure difference makes it difficult for the first gas to enter the conveying section 130.

The second treatment section 150 includes a treatment chamber 151, a gas supply line 152, and an evacuation line 153.

The treatment chamber 151 is connected to the gas supply line 152 including a gas supply source S2. With this configuration, the treatment chamber 151 is configured such that the second gas can be introduced in the inside. The second gas is carbon monoxide or carbon dioxide. Specifically, mixture gas between rare gas such as argon and carbon dioxide for example. In this case, the amount of carbon dioxide contained in the second gas can also be set as appropriate and is about 5% in a volume ratio for example.

The treatment chamber 151 is connected to the evacuation line 153 including a pump P3. With this configuration, the treatment chamber 151 is configured to be capable of being maintained at a predetermined pressure-reduced atmosphere. It should be noted that the internal pressure of the treatment chamber 151 may be equal to or higher than the internal pressure of the treatment chamber 141.

The conveying mechanism 170 includes a payout roller 171, a main roller 172, and a take-up roller 173.

The payout roller 171, the main roller 172, and the take-up roller 173 each include a rotary drive unit not shown in the figure and is each configured to be rotatable in the arrow direction in Fig. 4 about the Z-axis at a predetermined rotation speed. With this configuration, a base material F is conveyed at a predetermined conveyance speed from the payout roller 171 to the take-up roller 173 in the vacuum chamber 110.

The main roller 172 is disposed between the payout roller 171 and the take-up roller 173 in a conveyance direction of the base material F. The main roller 172 is disposed at such a position that at least a part of a lower portion in the Y-axis direction faces the deposition section 120 through an aperture 111a provided in the partition plate 111. With this configuration, the main roller 172 faces the aperture 111a with a predetermined space therebetween and faces the evaporation source 121 in the Y-axis direction.

The main roller 172 may be formed in a tubular shape from a metal material such as stainless steel, iron, and aluminum and a temperature control mechanism such as a temperature control medium circulation system not shown in the figure for example may be provided in the inside. The size of the main roller 172 is not particularly limited and the width dimension in the Z-axis direction is typically set to be larger than the width dimension of the base material F in the Z-axis direction.

The base material F is a long film cut into a predetermined width for example. The base material F is made of metal such as copper, aluminum, nickel, and stainless steel. Not limited thereto, a resin film such as an oriented polypropylene (OPP) film, a polyethylene terephthalate (PET) film, a poly phenylene sulfide (PPS) film, and a polyimide (PI) film may be used for the base material F. The thickness of the base material F is not particularly limited and is several µm to several tens of µm for example. Further, the width and length of the base material F are also not particularly limited and can be determined depending on purposes as appropriate.

In accordance with the thin film formation apparatus 202 configured in the above-mentioned manner, it is possible to successively perform deposition of the lithium metal film 11A on the base material F at the deposition section 120, formation of the lithium oxide film 11B at the first treatment section 140 (treatment chamber 141), and formation of the lithium carbonate film 11C at the second treatment section 150 (treatment chamber 151).

In order to form the lithium oxide film 11B and the lithium carbonate film 11C with the predetermined thickness, a plurality of guide rollers may be arranged in the treatment chambers 141 and 151 such that the path of the base material F which passes through the treatment chambers 141 and 151 can be adjusted to have an arbitrary length.

Although the embodiments of the present invention have been described above, the present invention is not limited only to the above-mentioned embodiments and various modifications can be made as a matter of course.

For example, in the above-mentioned embodiments, the vacuum deposition is employed as an example of the deposition method, though not limited thereto. Molecular beam deposition, ion plating, ion beam deposition, or the like may be employed.

Further, in the above-mentioned embodiments, the present invention is applied to formation of the electrode material thin film for the lithium metal battery, though not limited thereto. For example, the present invention is applicable also to manufacture for a solid-state lithium target for a neutron generation source.

### Reference Signs List

10, F base material
11 lithium electrode
11A lithium metal film
11B lithium oxide film
11C lithium carbonate film
21A, 120 deposition section
21B, 140 first treatment section
21C, 150 second treatment section
100 negative electrode for a lithium metal battery
201, 202 thin film formation apparatus

## Claims

1. A thin film formation method, comprising:
depositing a lithium metal film (11A) on a base material (10) in a vacuum chamber (110);
oxidizing a surface of the lithium metal film (11A) by using oxygen in the vacuum chamber (110); and
carbonizing the oxidized surface of the lithium metal film (11A) by using carbon monoxide or carbon dioxide in the vacuum chamber (110).

2. The thin film formation method according to claim 1, wherein
the step of oxidizing the surface of the lithium metal film (11A) includes forming a lithium oxide film (11B) having a first thickness on the surface, and
the step of carbonizing the surface of the lithium metal film (11A) includes forming a lithium carbonate film (11C) having a second thickness on the surface,
the second thickness being equal to or smaller than the first thickness.

3. The thin film formation method according to claim 2, wherein
the first thickness is 10 nm or more and 150 nm or less.

4. The thin film formation method according to claim 3, wherein
the second thickness is 10 nm or more and 50 nm or less.

5. A thin film formation apparatus (201), comprising:
a deposition section (21A) that includes an evaporation source (121) of lithium metal and forms a lithium metal film (11A) on a base material (10);
a first treatment section (21B, 140) including a first treatment chamber (141) for oxidizing a surface of the lithium metal film (11A); and
a second treatment section (21C, 150) including a second treatment chamber (151) for carbonizing the oxidized surface of the lithium metal film (11A).

## Patentansprüche

1. Verfahren zum Herstellen einer Dünnschicht, mit den Schritten:
Aufbringen einer Lithiummetallschicht (11A) auf einem Basismaterial (10) in einer Vakuumkammer (110);
Oxidieren einer Oberfläche der Lithiummetallschicht (11A) unter Verwendung von Sauerstoff in der Vakuumkammer (110); und
Karbonisieren der oxidierten Oberfläche der Lithiummetallschicht (11A) unter Verwendung von Kohlenmonoxid oder Kohlendioxids in der Vakuumkammer (110).

2. Verfahren zum Herstellen einer Dünnschicht nach Anspruch 1, wobei
der Schritt zum Oxidieren der Oberfläche der Lithiummetallschicht (11A) das Ausbilden einer Lithiumoxidschicht (11B) mit einer ersten Dicke auf der Oberfläche aufweist, und
der Schritt zum Karbonisieren der Oberfläche der Lithiummetallschicht (11A) das Ausbilden einer Lithiumcarbonatschicht (11C) mit einer zweiten Dicke auf der Oberfläche aufweist,
wobei die zweite Dicke kleiner oder gleich der ersten Dicke ist.

3. Verfahren zum Ausbilden einer Dünnschicht nach Anspruch 2, wobei
die erste Dicke 10 nm oder mehr und 150 nm oder weniger beträgt.

4. Verfahren zum Ausbilden einer Dünnschicht nach Anspruch 3, wobei
die zweite Dicke 10 nm oder mehr und 50 nm oder weniger beträgt.

5. Vorrichtung (201) zum Ausbilden einer Dünnschicht, mit:
einem Aufbringungsabschnitt (21A), der eine Verdampfungsquelle (121) für Lithiummetall enthält und eine Lithiummetallschicht (11A) auf einem Basismaterial (10) ausbildet;
einen ersten Behandlungsabschnitt (21B, 140) mit einer ersten Behandlungskammer (141) zum Oxidieren einer Oberfläche der Lithiummetallschicht (11A); und
einen zweiten Behandlungsabschnitt (21C, 150) mit einer zweiten Behandlungskammer (151) zum Karbonisieren der oxidierten Oberfläche der Lithiummetallschicht (11A).

## Revendications

1. Procédé de formation d'un film mince comprenant :
le dépôt d'un film métallique de lithium (11A) sur un matériau de base (10) dans une chambre sous vide (110) ;
l'oxydation d'une surface du film métallique de lithium (11A) en utilisant de l'oxygène dans la chambre sous vide (110) ; et
la carbonisation de la surface oxydée du film métallique de lithium (11A) en utilisant du monoxyde de carbone ou du dioxyde de carbone dans la chambre sous vide (110).

2. Procédé de formation d'un film mince selon la revendication 1, dans lequel
l'étape d'oxydation de la surface du film métallique de lithium (11A) comporte la formation sur la surface d'un film d'oxyde de lithium (11B) ayant une première épaisseur, et
l'étape de carbonisation de la surface du film métallique de lithium (11a) comporte la formation sur la surface d'un film de carbonate de lithium (11C) ayant une deuxième épaisseur,
la deuxième épaisseur étant inférieure ou égale à la première épaisseur.

3. Procédé de formation d'un film mince selon la revendication 2, dans lequel
la première épaisseur est égale ou supérieure à 10 nm et inférieure ou égale à 150 nm.

4. Procédé de formation d'un film mince selon la revendication 3, dans lequel
la deuxième épaisseur est égale ou supérieure à 10 nm et inférieure ou égale à 50 nm.

5. Appareil de formation d'un film mince (201) comprenant :
une section de dépôt (21A) qui comporte une source d'évaporation (121) du métal lithium et forme un film métallique de lithium (11A) sur un matériau de base (10) ;
une première section de traitement (21B, 140) incluant une première chambre de traitement (141) pour oxyder une surface du film métallique de lithium (11A) ; et
une deuxième section de traitement (21C, 150) incluant une deuxième chambre de traitement (151) pour carboniser la surface oxydée du film métallique de lithium (11A).
